# EUROPÄISCHE PATENTSCHRIFT

(11) **EP 2 480 396 B1**
(45) Veröffentlichungstag und Bekanntmachung des Hinweises auf die Patenterteilung: **17.05.2017**
(21) Anmeldenummer: 10779209.5
(22) Anmeldetag: 24.09.2010
(51) Int. Cl.: B29C 65/02, H05K 5/06, B29C 65/16, B29C 65/06, B29C 65/08, B60R 21/013, B29L 22/00

(54) **VERFAHREN ZUM VERSCHWEISSEN EINES KUNSTSTOFFGEHÄUSES**
METHOD FOR WELDING A PLASTIC HOUSING
PROCÉDÉ DE SOUDAGE D'UN BOÎTIER EN PLASTIQUE

(30) Priorität: 26.09.2009 DE 102009043200
(43) Veröffentlichungstag der Anmeldung: 01.08.2012
(73) Patentinhaber: Continental Automotive GmbH, 30165 Hannover (DE)
(72) Erfinder: FRENZEL, Henryk, 93059 Regensburg (DE); MÜLLER, Volker, 51371 Leverkusen (DE)
(74) Vertreter: Büchner, Jörg
(86) Internationale Anmeldenummer: PCT/DE2010/001121
(87) Internationale Veröffentlichungsnummer: WO 2011/035770

(56) Entgegenhaltungen:
- WO-A1-00/41321
- DE-A1-102009 023 323
- FR-A1- 2 657 490
- JP-A- 3 150 071
- JP-A- 61 248 729
- US-A- 4 631 685

## Beschreibung

Die Erfindung betrifft ein Verfahren zum Verschweißen eines Kunststoffgehäuses gemäß dem Oberbegriff von Anspruch 1.

Zum Verschließen von Kunststoffgehäusen insbesondere elektronischer Baugruppen, wie Kraftfahrzeugsteuergeräten wird mittlerweile häufig ein Verschweißen der Kunststoffteile eingesetzt, wobei die Einbringung der Wärmeenergie durch einen Laser besonders bevorzugt ist, weil dabei die Wärmeenergie besonders genau an die innere Verbindungsstelle zwischen den Gehäuseteilen eingebracht werden kann und ein besonders gleichmäßiger und allseits dichter Schweißvorgang erreicht werden kann.

Bei elektronischer Baugruppen, wie beispielsweise Kraftfahrzeugsteuergeräten ist im Inneren des Gehäuses ein Schaltungsträger, wie beispielweise eine Leiterplatte angeordnet, die ihrerseits an einer Gehäusehälfte befestigt werden muss, insbesondere wenn auf diesem Schaltungsträger beschleunigungsempfindliche Sensoren angeordnet sind, welche eine entsprechend starre Befestigung zur Aufnahme der zu sensierenden Beschleunigungen benötigen.

Aus der DE 102005000160 A1 ist dabei ein Verfahren und eine Vorrichtung zum formschlüssigen Verbinden zweier Bauteile durch plastische Deformation eines Bauteils während eines Laserschweißvorgangs bekannt, wobei an einer Gehäuseseite ein Bolzen durch ein Öffnung in der Leiterplatte geführt und dieser Bolzen durch Laserstrahlung erwärmt und durch Druck so umgeformt wird, dass sich ein Nietkopf bildet. Dieses Verfahren setzt das Einbringen von Laserstrahlung an zwei unterschiedlichen Positionen des Gehäuses sowie Öffnungen für die Bolzen auf der Leiterplatte voraus, so dass die nutzbare Leiterplattenfläche reduziert wird.

Aus der WO 00/41321 A1 ist darüber hinaus auch ein elektronisches Gehäuse zu entnehmen, bei dem Anschläge am Gehäuse die Leiterplatte fixieren und die Gehäusehälften beispielsweise durch Ultraschallschweißen verbunden sein können. Zum Toleranzausgleich ist ein Kissen zwischen den Gehäusehälften zu entnehmen, welches die Leiterplatte auch gegenüber dem Schmelzbereich abdichtet.

Die Aufgabe der vorliegenden Erfindung ist es, ein Verfahren zum Verschweißen eines Kunststoffgehäuses anzugeben, bei dem besonders preiswert und dennoch sicher die Leiterplatte befestigt werden kann.

Diese Aufgabe wird durch die Merkmale der unabhängigen Ansprüche gelöst. Vorteilhafte Weiterbildungen der Erfindung ergeben sind aus den Unteransprüchen. Ein wesentlicher Gedanke der Erfindung besteht darin, dass beim Verschweißen der beiden Gehäuseteile an einem umlaufenden Rand entstehende Schmelze des Kunststoffs eine vorgegebene Randzone der Leiterplatte erreicht und nach dem Auskühlen die Leiterplatte im Gehäuse fixiert. Diese Fixierung wird also über eine kraft- und formschlüssige Einbettung der Leiterplatte durch den Kunststoff der wegfließenden Schmelze direkt beim Verschließen des Gehäuses in einem Arbeitsgang und mit einem Laserstrahl direkt auf den umlaufenden Rand des Gehäuses realisiert, so dass eine Heiznietumformung von zusätzlichen Nieten im Inneren des Gehäuses enfallen kann.

Während dem Verschweißen erfolgt vorzugsweise ein Zusammenpressen der Gehäuseteile zueinander, um eine gute Vernetzung an der Schweißnaht zwischen den beiden Gehäuseteilen und ein ausreichend starkes Fliessen der Schmelze zu erreichen.

Zudem kann durch Andrücken des Deckels auf die Leiterplatte und die Gehäuseunterseite bis zum Erkalten der Schmelze eine entsprechende Verspannung erzeugt und aufrecht erhalten werden, die eine dauerhafte und auch vibrationsfreie Fixierung der Leiterplatte ermöglicht.

Um diese Fixierung besonders prozesssicher auszugestalten und selbst bei Maßtoleranzen auf Seiten der Kunststoffteile oder Leiterplatte ausgleichen zu können, ist im Schweißbereich zwischen den Gehäuseteilen vor dem Verschweißen ein Übermaß vorgesehen und wird das Verschweißen erst dann beendet wird, wenn ein vorgegebener Verformungsweg oder eine vorgegebene Gegenkraft erreicht, vorzugsweise der Endanschlag erreicht ist. Das Übermaß ist dabei vorzugsweise so bemessen, dass durch Abbau dieses Übermaßes ausreichend Schmelze erzeugt wurde, um die Leiterplatte zu fixieren.

Zudem wird in einem Ausführungsbeispiel vorzugsweise die Leiterplatte in einem Gehäuseteil eingelegt wird und ist am anderen Gehäuseteil eine Ausformung zur Leiterplatte hin vorgesehen, die zumindest zum Endzeitpunkt des Verschweißens die Leiterplatte erreicht und die Leiterplatte während des Auskühlens in einer vorgegebenen Position hält. So kann ein Wegschwimmen der Leiterplatte vor dem Erstarren der Schmelze verhindert werden.

Gleichzeitig kann diese Ausformung als Endanschlag für den Verformungsweg genutzt werden und zudem einen Hohlraum zwischen Schweißbereich, Ausformung und Leiterplatte bilden, wobei dieser Hohlraum während des Verschweißens zumindest teilweise mit der entstehenden Schmelze gefüllt wird.

Durch eine Abschrägung oder Aussparung an zumindest einem der Gehäuseteile zumindest in demjenigen Teilbereich, der zur Leiterplatte hin gerichtet ist, kann der Schmelze eine bevorzugte Fliessrichtung zur Leiterplatte hin vorgegeben werden.

Dieses Verfahren wird eingesetzt, um eine elektronische Leiterplatte in einem Kunststoffgehäuse vorzugsweise ausschliesslich mittels der beim Laserschweißen des Gehäuses an dessen Rand entstehenden Schmelze gemäß diesem Verfahren zu befestigen. Selbst bei höheren Fertigungstoleranzen oder Variationen an Leiterplattendicken kann eine sichere feste Fixierung erzeugt werden und ist diese geeignet für eine vibrationsfreie Montage der PCB ohne zusätzliche Bauteile (z.B. Schrauben, Kleben) und ist selbst zur Übertragung von Crashimpulsen an Sensoren auf der Leiterplatte geeignet. Parallel erfolgt natürlich auch ein wasserdichter Gehäuseverschluß.

Bei der Erfindung handelt es sich also um ein neues Konzept zum Verschließen eines Kunststoffgehäuses mit einem Deckel, bei gleichzeitiger Befestigung einer Leiterplatte, während eines Schweißvorganges, z.B. via Laser. Das Ziel ist es die Leiterplatte so zu befestigen das sie für Crashsensierung verwendet werden kann.

Die Erfindung wird nun nachfolgend anhand von Ausführungsbeispielen unter Zuhilfenahme der Figuren näher erläutert. Im Folgenden können für funktional gleiche und/oder gleiche Elemente mit den gleichen Bezugsziffern bezeichnet sein.

Es ist dabei hervorzuheben, dass es für die Erfindung völlig unerheblich ist, welches der Gehäuseteile Deckel bzw. Unterteil sind und ob die nachfolgend diskutierten Ausformungen am Deckel bzw. Unterteil vorhanden sind. Einzig deren relative Lage zur Leiterplatte ist für die Funktionsweise relevant.

Auch wird im folgenden in den Ausführungsbeispielen immer das bevorzugte Laserschweißen diskutiert, ist jedoch die Erfindung auch für andere Formen der lokalen Verschweißung, wie Reibschweißen, Ultraschallschweißen usw. geeignet.

Es zeigen
- Fig. 1:: Erstes Ausführungsbeispiel mit Gehäusedeckel, Gehäuseunterteil und Leiterplatte zu Beginn des Schweißvorgangs
- Fig. 2:: Erstes Ausführungsbeispiel mit Gehäusedeckel, Gehäuseunterteil und Leiterplatte nach Beendigung des Schweißvorgangs
- Fig. 3:: Zweites Ausführungsbeispiel mit Gehäusedeckel, Gehäuseunterteil und Leiterplatte zu Beginn des Schweißvorgangs
- Fig.4:: Zweites Ausführungsbeispiel mit Gehäusedeckel, Gehäuseunterteil und Leiterplatte nach Beendigung des Schweißvorgangs
- Fig. 5:: Weiteres Ausführungsbeispiel zu Beginn des Schweißvorgangs
- Fig.6:: Ausführungsbeispiel gemäß Fig. 5 nach Beendigung des Schweißvorgangs
- Fig.7:: Kraftverlauf

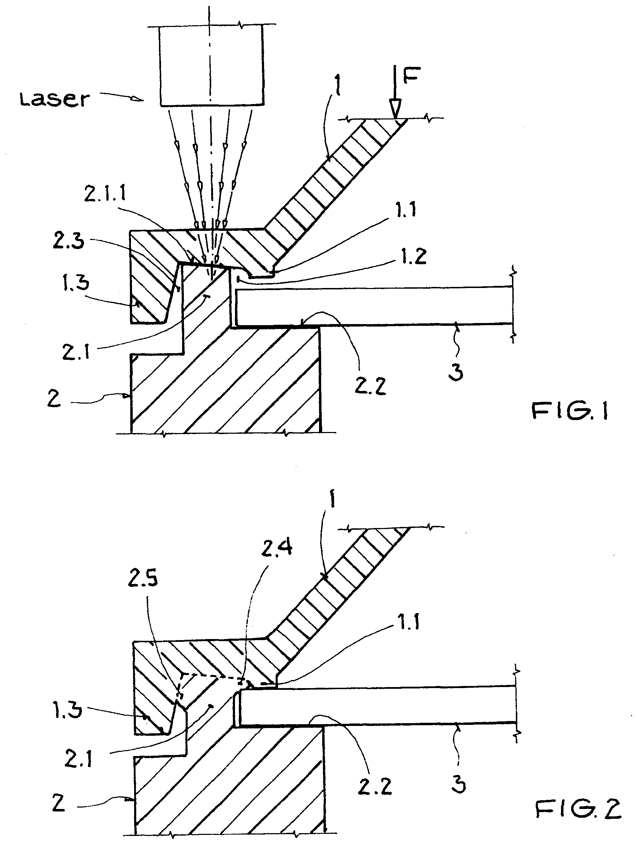

Figur 1 zeigt ein erstes Ausführungsbeispiel mit Gehäusedeckel 1, Gehäuseunterteil 2 und Leiterplatte 3 zu Beginn des Schweißvorgangs. Am Deckel 1 ist eine Ausformung 1.1 zur Leiterplatte hin, eine äußere Nase 1.3 zum Außenraum des Gehäuses hin sowie ein Aufnahmeraum 1.2 für Schmelze zwischen der äußeren Nase 1.3 am Deckel und einer Ausformung 2.1 am Gehäuseunterteil vorgesehen.

Das Gehäuseunterteil 2 weist eine Ausformung 2.1 mit einem Übermaß auf, wobei dieses Übermaß sich gegenüber der äußeren Nase 1.3 und/oder gegenüber der Ausformung 1.1 am Deckel ergibt und ein definiertes Materialvolumen an Schmelze bestimmt, welches während des Schweißens aufgeschmolzen und seitlich weggedrückt wird und zwar zumindest teilweise, vorzugsweise sogar überwiegend hin zur Leiterplatte.

So durchdringt ein Laserstrahl an der gezeigten Stelle und Richtung den Deckel 1 und erwärmt die Ausformung 2.1 des gegenüberliegenden Gehäuseunterteils 2.

Der Deckel 1 ist durch entsprechende Materialwahl zumindest in dem vom Laser durchstrahlten Bereich so gestaltet, dass er einen großen Anteil des Laserlichts zur Oberfläche 2.1.1 der gegenüberliegenden Ausformung 2.1 hindurchläßt, während dort durch entsprechende Materialwahl, bspw. Einbringung von Russpartikeln usw. eine besonders hohe Absorption und damit Umwandlung des Laserlichts in Wärme und damit Erzeugung von Kunststoffschmelze bewirkt wird.

Der Deckel 1 weist in diesem bevorzugten Ausführungsbeispiel eine Ausformung 1.1 zur Leiterplatte 3 hin auf. Diese Ausformung 1.1 weist einen Abstand zur Schweißzone bzw. der Ausformung 2.1 auf, so daß dieser Abstand vor dem Verschweißen einen Hohlraum 1.2 zwischen Schweißbereich 2.1.1, Ausformung 1.1 und Leiterplatte 3 bildet, wobei dieser Hohlraum 1.2 während des Verschweißens zumindest teilweise mit der entstehenden Schmelze 2.4 gefüllt wird, wie dies im Vergleich zur Figur 2 besonders gut deutlich wird.

Während dem Verschweißen erfolgt ein Zusammenpressen der Gehäuseteile 1,2 zueinander und wird das Verschweißen erst dann beendet, wenn eine vorgegebene Gegenkraft erreicht oder ein vorgegebener Verpressweg der Gehäuseteile 1,2 zueinander zurückgelegt wurde. Ein entsprechender Anstieg der Gegenkraft kann insbesondere dadurch erreicht werden, dass an einem Gehäuseteil ein Endanschlag 1.1, 1.3 vorgesehen ist und das Verschweißen erst dann beendet wird, wenn der Endanschlag erreicht wird. Diesen Endanschlag kann die äußere Nase 1.3 oder bevorzugt die zur Leiterplatte hin gerichtete Ausformung 1.1 übernehmen.

Wird nämlich die Leiterplatte 3 in das Gehäuseunterteil 2 an der Auflagefläche 2.2 eingelegt und erreicht die Ausformung 1.1 zumindest zum Endzeitpunkt des Verschweißens die Leiterplatte 3, so kann diese Ausformung 1.1 die Leiterplatte 3 während des Auskühlens in einer vorgegebenen Position halten und wird ein Aufschwimmen oder Verschieben der Leiterplatte 3 verhindert. Da das Kunststoffmaterial beim Abkühlen zudem schrumpft, wird die Verspannung und Fixierung der Leiterplatte 3 im Gehäuse nur noch verbessert.

Zumindest an einem der Gehäuseteile zumindest in demjenigen Teilbereich, der zur Leiterplatte 3 hin gerichtet ist, ist eine Abschrägung oder Aussparung zur Leiterplatte hin ausgebildet, um der Schmelze 2.4 eine bevorzugte Fliessrichtung zur Leiterplatte 3 hin vorzugeben. Im ersten Ausführungsbeispiel gemäß der Figuren 1 und 2 wird dazu die Ausformung 2.1 an ihrer Oberseite 2.1.1 über die gesamte Fläche angeschrägt und ist vorzugsweise auch die Gegenseite am Deckel 1 so angeschrägt gestaltet. Dadurch entsteht beim Anpressen des Deckels 1 auf die verflüssigte Schmelze eine Querkraft hin in den Hohlraum, 1.2, der durch die Schmelze 2.4 bevorzugt befüllt wird. Zusätzlich können am Deckel 1 oder der Ausformung 2.1 Rillen oder ähnliche Aussparungen vorgesehen sein, die ebenfalls ein entsprechend starkes Abfließen der Schmelze ermöglichen.

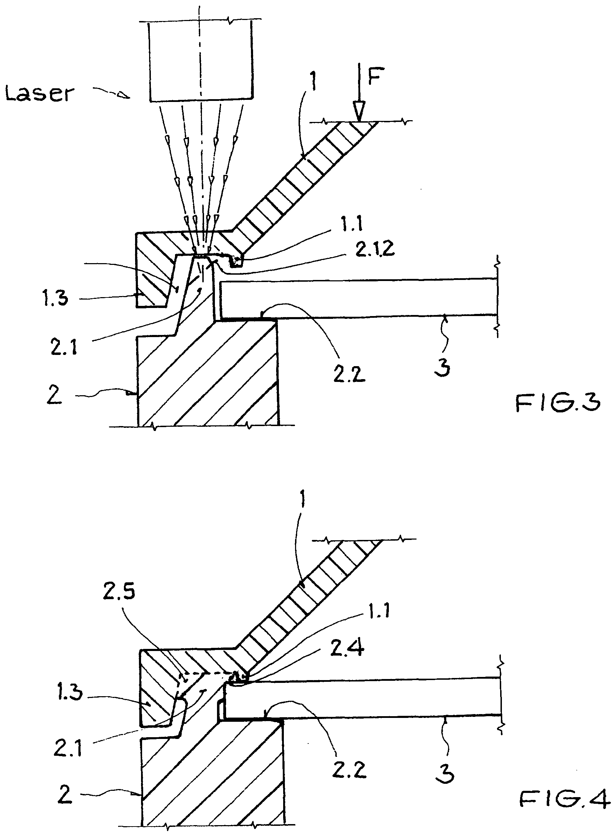

Die Figuren 3 und 4 zeigen ein abgewandeltes zweites Ausführungsbeispiel, bei dem ein Teil der Schmelze auch gezielt in einen Aufnahmeraum 2.3 hin geleitet wird. Diese ur Gehäuseaußenseite abgeflossene Schmelze 2.5 fixiert die äußere Nase 1.3 zusätzlich an der Ausformung 2.1 und dichtet das Gehäuse großflächig ab.

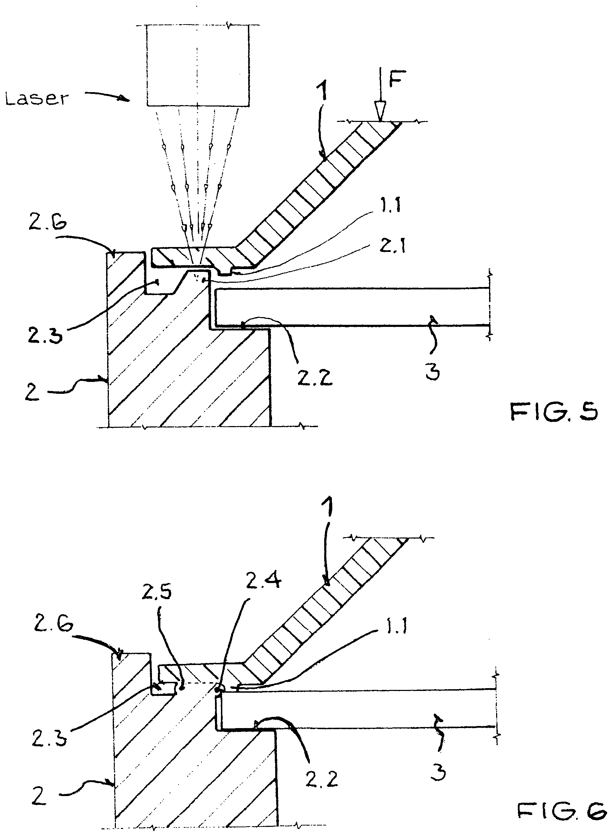

Figuren 5 und 6 zeigen ein weiteres Ausführungsbeispiel. Das Gehäuseunterteil 2 weist eine Ausformung 2.1 mit einem Übermaß auf, wobei dieses Übermaß sich gegenüber der äußeren Nase 1.3 und/oder gegenüber der Ausformung 1.1 am Deckel ergibt und ein definiertes Materialvolumen an Schmelze bestimmt, welches während des Schweißens aufgeschmolzen. So durchdringt ein Laserstrahl an der gezeigten Stelle und Richtung den Deckel 1 und erwärmt die Ausformung 2.1 des gegenüberliegenden Gehäuseunterteils 2.

Der Deckel 1 ist durch entsprechende Materialwahl zumindest in dem vom Laser durchstrahlten Bereich so gestaltet, dass er einen großen Anteil des Laserlichts zur Oberfläche 2.1.1 der gegenüberliegenden Ausformung 2.1 hindurchläßt, während dort durch entsprechende Materialwahl, bspw. Einbringung von Russpartikeln usw. eine besonders hohe Absorption und damit Umwandlung des Laserlichts in Wärme und damit Erzeugung von Kunststoffschmelze bewirkt wird.

Der Deckel 1 weist eine Ausformung 1.1 zur Leiterplatte 3 hin auf. Während dem Verschweißen erfolgt ein Zusammenpressen der Gehäuseteile 1,2 zueinander und wird das Verschweißen erst dann beendet, wenn eine vorgegebene Gegenkraft erreicht oder ein vorgegebener Verpressweg der Gehäuseteile 1,2 zueinander zurückgelegt wurde. Ein entsprechender Anstieg der Gegenkraft wird dann erreicht, wenn die Ausformung 1.1 auf die Leiterplatte 3 aufsetzt und eine Vorspannung im Deckel 1 entsteht.

Wird die Leiterplatte 3 in das Gehäuseunterteil 2 an der Auflagefläche 2.2 eingelegt und erreicht die Ausformung 1.1 zumindest zum Endzeitpunkt des Verschweißens die Leiterplatte 3, so kann diese Ausformung 1.1 die Leiterplatte 3 während des Auskühlens in einer vorgegebenen Position halten und wird ein Aufschwimmen oder Verschieben der Leiterplatte 3 verhindert. Da das Kunststoffmaterial beim Abkühlen zudem schrumpft, wird die Verspannung und Fixierung der Leiterplatte 3 im Gehäuse nur noch verbessert.

Eine äußere Nase 2.6, hier ausgeformt am Gehäuseunterteil, schützt zusätzlich die Schweißnaht gehen direkt darauf einwirkende Objekte.

Nochmals hervorgehoben werden soll, dass die Menge der erzeugten und durch die Anpressung verdrängten Schmelze deutlich höher ist als bei herkömmlichen Schweißverfahren und ein gezielter Materialabtrag und Zurückbildung des Übermaßes an der Ausformung 2.1 erfolgt.

Die beim Schweißen entstehende Schmelze wird durch eine vorgegebene Geometrie wird also hauptsächlich in Richtung Leiterplatte gelenkt und fixiert diese dadurch formschlüssig. Weiterhin wird die Leiterplatte durch Anschläge am Deckel kraftschlüssig im Gehäuse befestigt. Der Fügeweg ist, durch die Anschläge, abhängig von der Leiterplattendicke. Er liegt beispielsweise bei 0,4-0,8mm.

Diese Erfindung baut auf dem bekannten Laserschweißen von Kunststoffen auf. Die dort vorgegebene Grundgeometrie wurde so abgewandelt das die Schmelze sich nicht unkontrolliert in beide Richtungen verteilt sondern gezielt Richtung Gehäuseinnenraum gelenkt wird.

Der Vorteil dieses Konzeptes besteht darin, daß zum Befestigen der Leiterplatte und Verschließen des Gehäuses nur noch ein Arbeitsgang und ein auf dem umlaufenden Rand gerichteter Laserstrahl notwendig ist. Weiterhin ist die Befestigungsfläche der Leiterplatte weit größer als beim herkömmlichen Heißgasnieten, wobei der Platzbedarf auf der Leiterplatte aber geringer ist, da die Auflageflächen nur die Randzone der Leiterplatte beeinträchtigen. Diese Randzone wiederum ist aufgrund der Trennung der einzelnen Leiterplatte aus dem Nutzen als Sperrzone definiert.

Durch die größere Kontaktfläche treten Vorspannverluste durch Kriechen des Kunststoffes nicht störend in Erscheinung.

Neben den genannten Vorteilen ist dieses Verfahren sehr prozesssicher, da der Schweißweg vorzugsweise mithilfe einer Kraftauswertung gesteuert wird. Daher kann der Schweißprozess beim Anstieg der Vorspannkraft (nach Aufliegen der Anschläge auf die Leiterplatte) gestoppt werden, ohne dass die Leiterplatte zu stark beansprucht wird.

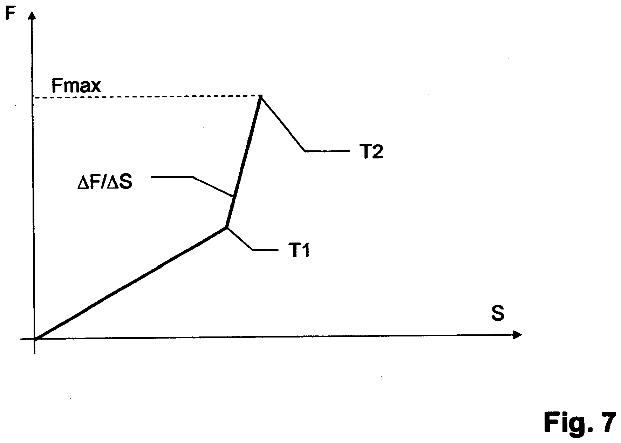

So zeigt die Figur 7 einen typischen Kraftverlauf über den Verstellweg s des Deckels relativ zur Leiterplatte mit einem deutlichen Anstieg der Gegenkraft bei Erreichen der Leiterplatte in T1, was damit die Abschaltung in T2 aktiviert. So kann eine Gegenkraft Fmax zur Abschaltung vorgegeben sein, die so dimensioniert ist, dass diese eben eine Verspannung zwischen Leiterplatte und Deckel sicherstellt. Alternativ kann auch die Veränderung des Anstiegs, also die relative Änderung der Kraft über den Verstellweg ΔF/ΔS oder über die Zeit ΔF/ΔT berücksichtigt werden.

Außerdem ist das Verschweißen eines Deckels erheblich materialsparender als das Vergießen der Leiterplatte. Neben der Materialersparnis gegenüber dem Verguss spart ein Schweißvorgang auch erheblich Zeit, da die Schweißverbindung schneller auskühlt und nicht trocknen muss.

Die elektrische Kontaktierung der Leiterplatte kann sowohl auf herkömmliche Art, mit Pressfiteinsätzen, als auch mit Single-Pins oder direkten Verbindungen erfolgen.

Der entscheidende Punkt ist das während eines Schweißvorganges am Rand des Gehäuses entlang sowohl die Leiterplatte fixiert als auch das Gehäuse verschlossen wird.

### Bezugszeichenliste

- 1: Deckel
- 1.1: Ausformung am Deckel zur Leiterplatte hin
- 1.2: Aufnahmeraum für Schmelze zwischen der Ausformung am Deckel und einer Ausformung am Gehäuseunterteil zum Deckel hin
- 1.3: Äußere Nase am Deckel
- 2: Gehäuseunterteil
- 2.1: Ausformung am Gehäuseunterteil zum Deckel hin
- 2.1.1: Oberseite an der Ausformung 2.1
- 2.1.2: Abflussphase an der Ausformung 2.1
- 2.2: Auflagefläche für Leiterplatte
- 2.3: Aufnahmeraum zur Gehäuseaußenseite für überschüssige Schmelze
- 2.4: Zur Leiterplatte hin abgeflossene und erhärtete Schmelze
- 2.5: Zur Gehäuseaußenseite abgeflossene Schmelze
- 2.6: Äußere Nase am Gehäuseunterteil
- 3: Leiterplatte
- F: Kraft
- S: Verstellweg

## Patentansprüche

1. Verfahren zum Verschweißen eines Kunststoffgehäuses bestehend aus zwei Gehäuseteilen (1,2) an einem umlaufenden Rand beider Gehäuseteile, wobei im Gehäuse eine elektronische Leiterplatte (3) angeordnet ist, **dadurch gekennzeichnet, daß**
a) die beim Verschweißen am umlaufenden Rand beider Gehäuseteile entstehende Schmelze (2.4) des Kunststoffs eine Randzone der Leiterplatte (3) erreicht und
b) nach dem Auskühlen die Leiterplatte (3) im Gehäuse fixiert, wobei
c) während dem Verschweißen ein Zusammenpressen der Gehäuseteile (1,2) zueinander erfolgt und
d) im Schweißbereich zwischen den Gehäuseteilen (1,2) vor dem Verschweißen ein Übermaß vorgesehen ist und
e) das Verschweißen erst dann beendet wird, wenn eine vorgegebene Gegenkraft erreicht oder ein vorgegebener Verpressweg der Gehäuseteile (1,2) zueinander zurückgelegt wurde.

2. Verfahren nach Anspruch 1, **dadurch gekennzeichnet, dass** an einem Gehäuseteil ein Endanschlag (1.1, 1.3) vorgesehen ist und das Verschweißen erst dann beendet wird, wenn der Endanschlag erreicht wird.

3. Verfahren nach einem der vorangehenden Ansprüche, **dadurch gekennzeichnet, daß** die Leiterplatte (3) in einem Gehäuseteil (2) eingelegt (2.2) wird und am anderen Gehäuseteil (1) eine Ausformung (1.1) zur Leiterplatte hin vorgesehen ist, die Ausformung (1.1) zum Endzeitpunkt des Verschweißens die Leiterplatte (3) erreicht und die Leiterplatte (3) während des Auskühlens in einer vorgegebenen Position hält.

4. Verfahren nach Anspruch 3, **dadurch gekennzeichnet, daß** die Ausformung (1.1) zur Leiterplatte hin einen so vorgegebenen Abstand zum Schweißbereich (2.1.1) aufweist, daß dieser Abstand vor dem Verschweißen einen Hohlraum (1.2) zwischen Schweißbereich (2.1.1), Ausformung (1.1) und Leiterplatte (3) bildet, wobei dieser Hohlraum (1.2) während des Verschweißens zumindest teilweise mit der entstehenden Schmelze (2.4) gefüllt wird.

5. Verfahren nach einem der vorangehenden Ansprüche, **dadurch gekennzeichnet, daß** an zumindest einem der Gehäuseteile zumindest in demjenigen Teilbereich, der zur Leiterplatte (3) hin gerichtet ist, eine Abschrägung (2.1.1, 2.1.2) oder Aussparung zur Leiterplatte hin ausgebildet ist, um der Schmelze (2.4) eine bevorzugte Fliessrichtung zur Leiterplatte (3) hin vorzugeben.

6. Elektronische Baugruppe bestehend aus einem Kunststoffgehäuse mit zwei Gehäuseteilen, wobei im Gehäuse eine elektronische Leiterplatte angeordnet ist,
a) wobei die Leiterplatte (3) in einem Gehäuseteil (2) eingelegt (2.2) ist und
b) am anderen Gehäuseteil (1) eine Ausformung (1.1) zur Leiterplatte hin vorgesehen ist, wobei die Ausformung (1.1) zum Endzeitpunkt des Verschweißens die Leiterplatte (3) erreicht und die Leiterplatte (3) während des Auskühlens in einer vorgegebenen Position hält,
**dadurch gekennzeichnet, dass** nach dem Verfahren nach einem der vorangehenden Ansprüche
c) die beim Verschweißen am umlaufenden Rand beider Gehäuseteile entstehende Schmelze (2.4) des Kunststoffs eine Randzone der Leiterplatte (3) erreicht und
d) nach dem Auskühlen die Leiterplatte (3) im Gehäuse fixiert.

7. Elektronische Baugruppe nach Anspruch 6, **dadurch gekennzeichnet, dass** die Ausformung (1.1) zur Leiterplatte hin einen so vorgegebenen Abstand zum Schweißbereich (2.1.1) aufweist, dass dieser Abstand vor dem Verschweißen einen Hohlraum (1.2) zwischen Schweißbereich (2.1.1), Ausformung (1.1) und Leiterplatte (3) bildet, wobei dieser Hohlraum (1.2) nach dem Verschweißen zumindest teilweise mit der entstehenden Schmelze (2.4) gefüllt ist.

## Claims

1. A method for welding a plastic housing comprising two housing parts (1,2) along a circumferential edge of both housing parts, wherein an electronic printed circuit board (3) is arranged in the housing, **characterized in that**
a) the plastic melt (2.4) produced along the circumferential edge of both housing parts during welding reaches a peripheral zone of the printed circuit board (3), and
b) the printed circuit board (3) is fixed in the housing after cool-down, wherein
c) the housing parts (1,2) are pressed against each other during welding, and
d) an excess dimension is provided in the welding area between the housing parts (1,2) prior to welding, and
e) welding is not finished until a predefined counteracting force is reached or a predefined pressing path of the housing parts (1,2) to each other has been covered.

2. The method according to Claim 1, **characterized in that** a final stop (1.1, 1.3) is provided on one housing part and welding is not finished until the final stop is reached.

3. The method according to any one of the preceding claims, **characterized in that** the printed circuit board (3) is placed (2.2) in one housing part (2) and a projection (1.1) towards the printed circuit board is provided on the other housing part (1), the projection (1.1) reaches the printed circuit board (3) at the end of welding and holds the printed circuit board (3) in a predefined position during cool-down.

4. The method according to Claim 3, **characterized in that** the projection (1.1) towards the printed circuit board is arranged at a predefined distance from the welding area (2.1.1), such that said distance defines a cavity (1.2) between the welding area (2.1.1), the projection (1.1) and the printed circuit board (3) prior to welding, wherein said cavity (1.2) is at least partly filled with the melt (2.4) produced during welding.

5. The method according to any one of the preceding claims, **characterized in that** a bevel (2.1.1, 2.1.2) or a recess is formed towards the printed circuit board on at least one of the housing parts, at least in the partial area facing the printed circuit board (3), in order to predefine a preferred direction of flow of the melt (2.4) towards the printed circuit board (3).

6. An electronic assembly consisting of a plastic housing comprising two housing parts, wherein an electronic printed circuit board is arranged in the housing,
a) wherein the printed circuit board (3) is placed (2.2) in one housing part (2), and
b) a projection (1.1) towards the printed circuit board is provided on the other housing part (1), wherein the projection (1.1) reaches the printed circuit board (3) at the end of welding and holds the printed circuit board (3) in a predefined position during cool-down, **characterized in that** according to the method according to any one of the preceding claims
c) the plastic melt (2.4) produced along the circumferential edge of both housing parts during welding reaches a peripheral zone of the printed circuit board (3), and
d) the printed circuit board (3) is fixed in the housing after cool-down.

7. The electronic assembly according to Claim 6, **characterized in that** the projection (1.1) towards the printed circuit board is arranged at a predefined distance from the welding area (2.1.1), such that said distance defines a cavity (1.2) between the welding area (2.1.1), the projection (1.1) and the printed circuit board (3) prior to welding, wherein said cavity (1.2) is at least partly filled with the melt (2.4) produced following welding.

## Revendications

1. Procédé de soudage d'un boîtier en plastique composé de deux parties de boîtier (1,2) sur un bord périphérique des deux parties de boîtier, une carte de circuit (3) électronique étant disposée dans le boîtier, **caractérisé en ce que**
a) la fonte (2.4) de matière plastique générée sur le bord périphérique des deux parties de boîtier lors du soudage atteint une zone de bord de la carte de circuit (3) et
b) la carte de circuit (3) est fixée dans le boîtier après refroidissement,
c) un assemblage par compression des parties de boîtier (1,2) étant effectué pendant le soudage, et
d) une surcote étant prévue dans la zone de soudure entre les parties de boîtier (1,2) avant soudage, et
e) le soudage n'étant terminé que lorsqu'une force opposée définie est atteinte ou une course définie d'assemblage par compression des parties de boîtier (1,2) est parcourue.

2. Procédé selon la revendication 1, **caractérisé en ce qu'**une butée finale (1.1, 1.3) est prévue sur une partie de boîtier, et **en ce que** le soudage n'est terminé que lorsque la butée finale est atteinte.

3. Procédé selon l'une des revendications précédentes, **caractérisé en ce que** la carte de circuit (3) est mise en place (2.2) dans une partie de boîtier (2) et une saillie (1.1) vers la carte de circuit est prévue sur l'autre partie de boîtier (1), ladite saillie (1.1) atteignant la carte de circuit (3) à la fin du soudage et maintenant la carte de circuit (3) dans une position prescrite pendant le refroidissement.

4. Procédé selon la revendication 3, **caractérisé en ce que** la saillie (1.1) vers la carte de circuit présente un espacement défini par rapport à la zone de soudure (2.1.1) tel que celui-ci forme une cavité (1.2) entre zone de soudure (2.1.1), saillie (1.1) et carte de circuit (3) avant soudage, ladite cavité (1.2) étant comblée au moins en partie avec la fonte (2.4) générée pendant le soudage.

5. Procédé selon l'une des revendications précédentes, **caractérisé en ce qu'**une inclinaison (2.1.1, 2.1.2) ou un évidement vers la carte de circuit sont formés au moins dans une des parties de boîtier, au moins dans la zone partielle opposée à la carte de circuit (3), pour définir un sens d'écoulement préférentiel de la fonte (2.4) vers la carte de circuit (3).

6. Groupe de composants électroniques consistant en un boîtier en plastique composé de deux parties de boîtier, une carte de circuit électronique étant disposée dans le boîtier,
a) la carte de circuit (3) étant mise en place (2.2) dans une partie de boîtier (2) et
b) une saillie (1.1) vers la carte de circuit étant prévue sur l'autre partie de boîtier (1), ladite saillie (1.1) atteignant la carte de circuit (3) à la fin du soudage et maintenant la carte de circuit (3) dans une position prescrite pendant le refroidissement,
**caractérisé en ce que**, suivant le procédé selon l'une des revendications précédentes,
c) la fonte (2.4) de matière plastique générée sur le bord périphérique des deux parties de boîtier lors du soudage atteint une zone de bord de la carte de circuit (3) et
d) fixe la carte de circuit (3) dans le boîtier après refroidissement.

7. Groupe de composants électroniques selon la revendication 6, **caractérisé en ce que** la saillie (1.1) vers la carte de circuit présente un espacement défini par rapport à la zone de soudure (2.1.1) tel que celui-ci forme une cavité (1.2) entre zone de soudure (2.1.1), saillie (1.1) et carte de circuit (3) avant soudage, ladite cavité (1.2) étant comblée au moins en partie avec la fonte (2.4) générée après le soudage.
